# EUROPÄISCHE PATENTSCHRIFT

(11) **EP 3 874 286 B1**
(45) Veröffentlichungstag und Bekanntmachung des Hinweises auf die Patenterteilung: **26.04.2023**
(21) Anmeldenummer: 19795511.5
(22) Anmeldetag: 23.10.2019
(51) Int. Cl.: G01R 33/06

(54) **SENSORANORDNUNG**
SENSOR ARRANGEMENT
SYSTÈME DE DÉTECTION

(30) Priorität: 31.10.2018 DE 102018218673
(43) Veröffentlichungstag der Anmeldung: 08.09.2021
(73) Patentinhaber: ZF Friedrichshafen AG, 88046 Friedrichshafen (DE)
(72) Erfinder: PFEIFER, Ralf, 49356 Diepholz (DE)
(86) Internationale Anmeldenummer: PCT/EP2019/078886
(87) Internationale Veröffentlichungsnummer: WO 2020/089014

(56) Entgegenhaltungen:
- WO-A1-2010/150933
- DE-A1-102014 223 884
- JP-A- 2010 040 177

## Beschreibung

Die vorliegende Erfindung betrifft eine Sensoranordnung.

Eine Sensoranordnung zur Bestimmung einer Positionsänderung eines Messobjekts, wobei die Sensoranordnung einen Magneten und einen Magnetfeldsensor aufweisen, die relativ zueinander bewegbar sind, ist beispielsweise aus der DE102014223884A1 bekannt.

Insbesondere betrifft die Erfindung eine Sensoranordnung in einer sicherheitsrelevanten Anwendung, beispielsweise zur Steuerung einer Funktion an Bord eines Kraftfahrzeugs.

An Bord eines Kraftfahrzeugs kann eine Funktion gesteuert werden, die Einfluss auf eine Fahrfunktion des Kraftfahrzeugs hat. Die Funktion kann insbesondere durch einen Fahrer des Kraftfahrzeugs mittels einer Eingabevorrichtung steuerbar sein, die eine mechanische Bewegung eines Betätigungselements in ein Steuersignal umsetzt. Wird die Funktion in einer nicht beabsichtigten Weise gesteuert, so kann eine Betriebssicherheit des Kraftfahrzeugs gefährdet sein. Die Eingabevorrichtung muss funktionssicher ausgeführt werden, um einer Fehlfunktion vorzubeugen.

Dazu können bestimmte nationale oder internationale Normen zur Funktionssicherheit einzuhalten sein, beispielsweise eine vorbestimmte ASIL-Fähigkeit der Eingabevorrichtung nach ISO 26262 oder IEC 61508. Zur Einhaltung der Normen sind unterschiedliche Maßnahmen bekannt, die häufig eine redundante Auslegung eines oder mehrerer Elemente umfassen. Eine solche Eingabevorrichtung kann kostenintensiv sein.

Eine der vorliegenden Erfindung zugrunde liegende Aufgabe liegt in der Bereitstellung einer Sensoranordnung und eines Steuerverfahrens, um eine Funktion an Bord eines Kraftfahrzeugs möglichst kostengünstig funktionssicher zu steuern. Die Erfindung löst diese Aufgabe mittels der Gegenstände der unabhängigen Ansprüche. Unteransprüche geben bevorzugte Ausführungsformen wieder.

Nach einem ersten Aspekt der Erfindung umfasst eine Sensoranordnung zur Steuerung einer Funktion an Bord eines Kraftfahrzeugs eine elektrische Spule zur Bereitstellung eines Magnetfeldes; einen Magnetfeldsensor; und ein magnetisches Flusselement zur Führung des Magnetfeldes zwischen der Spule und dem Magnetfeldsensor. Das magnetische Flusselement ist beweglich gelagert und derart geformt, dass das im Bereich des Magnetfeldsensors herrschende Magnetfeld von einer Position des Flusselements abhängig ist. Außerdem ist eine Verarbeitungseinrichtung zur Bestimmung der Position des Flusselements auf der Basis des mittels des Magnetfeldsensors bestimmten Magnetfelds vorgesehen, dadurch gekennzeichnet, dass das Flusselement bezüglich einer vorbestimmten Achse beweglich ist; und die Spule und der Magnetfeldsensor bezüglich dieser Achse axial versetzt sind.

Die Spule kann insbesondere als Struktur auf einer Leiterplatte ausgebildet werden, so dass kein spezielles Bauteil benötigt wird. Die Spule kann außerdem bevorzugt unterhalb des Magnetfeldsensors angebracht werden. Dabei wird vorteilhaft ausgenutzt, dass die Stärke des Magnetfeldes, welches zur Stimulation des Magnetfeldsensors bei geringen Strömen eine ausreichende Signalstärke im Magnetfeldsensor erzeugt.

Dadurch kann eine berührungslose, störungssichere Abtastung der Position des Flusselements erfolgen. Das Flusselement kann insbesondere Teil einer Eingabeeinrichtung an Bord des Kraftfahrzeugs sein, wobei die Bewegung des Flusselements mechanisch eingeschränkt sein kann, beispielsweise auf eine vorbestimmten Bewegungspfad, auf eine Verschiebung entlang oder eine Drehung um eine vorbestimmte Achse. Das magnetische Flusselement kann asymmetrisch ausbildet sein, um somit bei einer Veränderung der Position oder Orientierung des Flusselements eine Veränderung des Magnetfeldes, das vom Magnetfeldsensor abgetastet wird, zu bewirken.

Kosten für einen Permanentmagnet können eingespart werden. Die Stärke des Magnetfeldes gesteuert werden, um einen Messvorgang zu unterstützen. Die Anordnung kann verbessert kalibriert oder justiert werden, um eine Messgenauigkeit zu steigern. Die Bestimmung der Position kann mittels eines konstanten Magnetfelds erfolgen. Der Magnetfeldsensor ist weiter bevorzugt als mikroelektronisches oder mikromechanisches Bauelement ausgeführt, sodass es verbessert an eine als Mikrocomputer ausgeführte Verarbeitungseinrichtung angeschlossen werden kann. Derartige integrierte Sensoren können in verschiedenen Ausführungsformen erhältlich sein.

Es wird vorgeschlagen, dass Verarbeitungseinrichtung ferner dazu eingerichtet ist, einen durch die Spule fließenden Strom zu verändern, und zu bestimmen, ob eine Veränderung des mittels des Magnetfeldsensors bestimmten Magnetfelds einer aufgrund der Veränderung des Stroms erwarteten Veränderung entspricht. Anders ausgedrückt kann die Verarbeitungseinrichtung die Funktionsfähigkeit der Sensoranordnung überprüfen, indem die Magnetfeldbestimmung mit unterschiedlich starken Magnetfeldern überprüft wird.

Die Sensoranordnung kann dadurch Anforderungen an eine sicherheitskritische Komponente, beispielsweise nach ISO 26262, erfüllen. Der Magnetfeldsensor muss hierfür nicht redundant ausgeführt sein. Durch die Verwendbarkeit von Standard-Bauelementen können Kosten für die Sensoranordnung reduziert sein. Die erreichbare Sicherheit durch das vorgeschlagene dynamische Prinzip kann höher als die einer homogenen Redundanz liegen. Ein Hersteller der Sensoranordnung, der den Magnetfeldsensor zukauft, kann die Sicherheit der Anordnung selbst sicherstellen, ohne auf eine durch ihn nicht beeinflussbare Eigenschaft des Sensors angewiesen zu sein.

Stimmt das beobachtete Magnetfeld mit dem erwarteten nicht innerhalb vorbestimmter Grenzen überein, so kann ein Fehlersignal ausgegeben werden. Außerdem kann versucht werden, die Positionsbestimmung des Flusselements wiederherzustellen, indem das mittels der Spule bereitgestellte Magnetfeld verändert wird. Alternativ kann auch die Bestimmung der Position selbst angepasst werden, beispielsweise indem ein Messwert des Magnetfeldsensors in einer vorbestimmten Weise angepasst wird. Die Anpassung kann insbesondere eine Skalierung des Messwerts umfassen.

In einer Ausführungsform ist das magnetische Flusselement derart geformt, dass eine Stärke des im Bereich des Magnetfeldsensors herrschenden Magnetfelds von einer Position des Flusselements abhängig ist, wobei der Magnetfeldsensor dazu eingerichtet ist, die Stärke des in seinem Bereich herrschenden Magnetfelds zu bestimmen. In einer anderen Ausführungsform ist das magnetische Flusselement derart geformt, dass anstelle oder zusätzlich zur Stärke eine Richtung des im Bereich des Magnetfeldsensors herrschenden Magnetfelds von einer Position des Flusselements abhängig ist. Dabei ist der Magnetfeldsensor dazu eingerichtet, die Richtung des in seinem Bereich herrschenden Magnetfelds zu bestimmen. Die Richtungsbestimmung kann vorteilhaft sicherer oder verringerten Bestimmungsfehlern unterworfen sein.

Das Flusselement kann bezüglich einer vorbestimmten Achse beweglich sein, wobei die Spule und der Magnetfeldsensor bezüglich dieser Achse axial zueinander versetzt sind. Dabei kann das Flusselement entlang der Achse verschiebbar oder um die Achse drehbar gelagert sein. Auch eine kombinierte Bewegung, etwa entlang einer Schraubenlinie, ist denkbar. Die Achse verläuft bevorzugt durch die Spule in Richtung des dort bereitgestellten Magnetfelds. Durch den axialen Versatz kann das Flusselement das durch die Spule bereitgestellte Magnetfeld in einem Bereich großer Flussdichte aufnehmen und so verbessert in Richtung des Magnetfeldsensors führen. Ein Nutzsignal des Magnetfeldsensors kann dadurch vergrößert sein.

Das Flusselement kann derart geformt sein, dass die Breite eines Spalts zwischen dem Flusselement und dem Magnetfeldsensor von der Position des Flusselements abhängig ist. Die Breite des Spalts kann eine Stärke des Magnetfelds im Bereich des Magnetfeldsensors steuern, wobei ein großer Spalt zu einem kleinen Magnetfeld und ein kleiner Spalt zu einem großen Magnetfeld korrespondieren können. Die Position des Flusselements kann dann auf der Basis der Stärke des Magnetfelds bestimmt werden. Zusätzlich kann auch eine von der Position abhängige Richtung des Magnetfelds in die Positionsbestimmung einfließen.

Der Magnetfeldsensor kann dazu eingerichtet sein, das Magnetfeld entlang mehrerer unterschiedlicher Raumrichtungen zu bestimmen. Dazu kann der Magnetfeldsensor separate Vorrichtungen, jeweils zur Bestimmung des Magnetfelds in einer Raumrichtung, umfassen. Durch den Magnetfeldsensor können die Stärken entlang der Raumrichtungen separat voneinander bereitgestellt werden. Alternativ können Richtung und Stärke des Magnetfelds seitens des Magnetfeldsensors beispielsweise als vektorielle Größe bestimmt und ihre Komponenten bereitgestellt werden. In einer Ausführungsform ist der Magnetfeldsensor als zwei- oder dreidimensional wirkender Sensor gebildet. Durch die mehrfach vorgesehenen Vorrichtungen kann der Magnetfeldsensor über Redundanz verfügen. Sollte eine der Vorrichtungen ausfallen, so kann die Sensoranordnung auf der Basis einer anderen Vorrichtung weiterarbeiten können. Dazu ist der Magnetfeldsensor bevorzugt derart angebracht, dass bei einer Änderung der Position des Flusselements das Magnetfeld am Magnetfeldsensor entlang von wenigstens zwei Raumrichtungen verändert wird. Nach einem zweiten Aspekt umfasst ein Verfahren zur Steuerung einer Funktion an Bord eines Kraftfahrzeugs Schritte des Bereitstellens eines Magnetfeldes mittels einer elektrischen Spule; des Bestimmens eines im Bereich eines Magnetfeldsensors herrschenden Magnetfelds; wobei ein magnetisches Flusselement, das zur Führung des Magnetfeldes zwischen der Spule und dem Magnetfeldsensor eingerichtet ist, beweglich gelagert ist; wobei das magnetische Flusselement derart geformt ist, dass das im Bereich des Magnetfeldsensors herrschende Magnetfeld von einer Position des Flusselements abhängig und wobei das Flusselement bezüglich einer vorbestimmten Achse beweglich ist; und die Spule und der Magnetfeldsensor bezüglich dieser Achse axial versetzt sind; und des Bestimmens der Position des Flusselements auf der Basis des mittels des Magnetfeldsensors bestimmten Magnetfelds.

Das Verfahren kann ganz oder teilweise an einer hierin beschriebenen Sensoranordnung durchgeführt werden. Insbesondere kann das Verfahren durch eine als Mikrocomputer oder Mikrocontroller ausgebildete Verarbeitungseinrichtung der Sensoranordnung umgesetzt werden. Das Verfahren kann hierbei als Computerprogrammprodukt mit Programmcodemitteln vorliegen. Das Computerprogrammprodukt kann auf einem computerlesbaren Datenträger gespeichert sein. Vorteile oder Merkmale des Verfahrens können auf eine hierin beschriebene Vorrichtung übertragen werden oder umgekehrt.

In einer bevorzugten Ausführungsform wird ferner ein durch die Spule fließender Strom verändert und es wird bestimmt, ob eine Veränderung des mittels des Magnetfeldsensors bestimmten Magnetfelds einer aufgrund der Veränderung des Stroms erwarteten Veränderung entspricht. Bevorzugt wird periodisch zwischen einer Positions- und einer Funktionsbestimmung gewechselt. Die Position kann auch nacheinander bezüglich unterschiedlicher Magnetfelder bestimmt werden, um etwa einen Defekt zu erfassen, bei welchem ein Signal des Magnetfeldsensors nicht in erwarteter Weise von dem mittels der Spule bereitgestellten Magnetfeld abhängt, beispielsweise weil ein externes Magnetfeld überlagert ist.

Stromrichtungen zur Bestimmung der Position des Flusselements und zur Prüfung der Sensoranordnung können entgegengesetzte Polaritäten aufweisen. Dadurch kann auch eine Überprüfung außerhalb üblicher Messparameter der Sensoranordnung erfolgen. Eine Wahrscheinlichkeit, einen vorliegenden Defekt zu bestimmen, kann dadurch erhöht sein.

Die Erfindung umfasst weiterhin die Verwendung einer Sensoranordnung gemäß der vorhergehenden Beschreibung in einem Drehschalter eines Fahrzeugs, um eine Drehstellung des Drehschalters zu bestimmen. Dabei kann die Spule entlang einer Drehachse des Drehschalters positioniert werden. Das magnetische Flusselement kann mit einer Welle oder anderen beweglichen Teil des Drehschalters verbunden werden.

Die Erfindung wird nun mit Bezug auf die beigefügten Figuren genauer beschrieben, in denen:
- Figur 1: eine Eingabevorrichtung;
- Figur 2: ein Ablaufdiagramm eines Verfahrens;
- Figur 3: Ausführungsformen eines magnetischen Flusselements;
- Figur 4: einen beispielhaften zeitlichen Ablauf verschiedener Messungen an einer Sensoranordnung; und
- Figur 5: eine Draufsicht einer Ausführungsform einer Spule; darstellt.

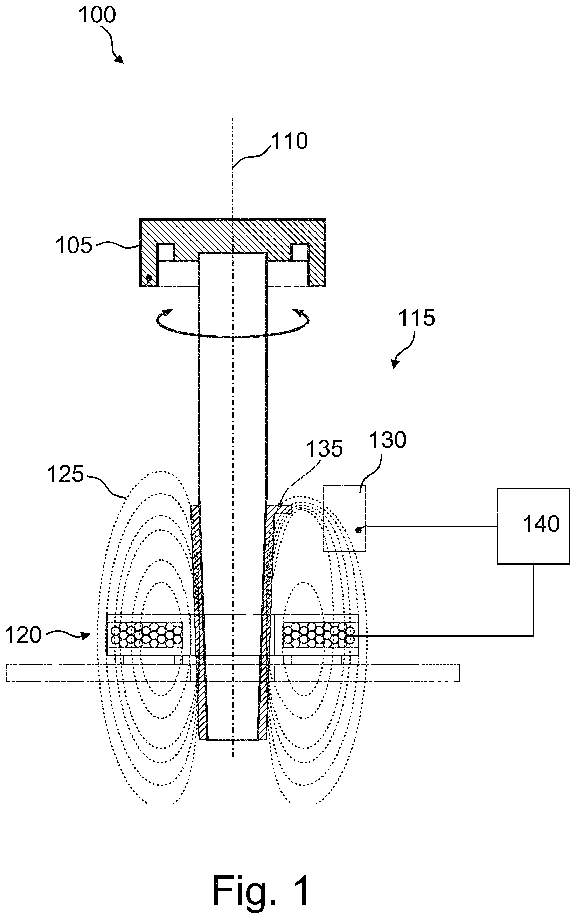

Figur 1 zeigt eine schematische Darstellung durch eine beispielhafte Eingabevorrichtung 100, die insbesondere zur Verwendung an Bord eines Kraftfahrzeugs eingerichtet ist, in einem Längsschnitt. Die Eingabevorrichtung 100 ist dazu eingerichtet, ein auf eine mechanische Betätigung hinweisendes Signal bereitzustellen und kann insbesondere zur Eingabe eines Fahrerwunsches an eine Vorrichtung verwendet werden, die eine Funktion des Kraftfahrzeugs beeinflussen kann, insbesondere eine Bewegung. Beispielsweise kann die Eingabevorrichtung zum Vorwählen oder Einlegen einer Gangstufe in einem Getriebe verwendet werden, das Teil eines Antriebsstrangs des Kraftfahrzeugs ist.

Die Eingabevorrichtung 100 umfasst ein Betätigungselement 105, das bezüglich einer Achse 110 beweglich angeordnet ist, und eine Sensoranordnung 115. Vorliegend wird von einer eindimensionalen Beweglichkeit des Betätigungselements 105 bezüglich der Sensoranordnung 115 ausgegangen. In der dargestellten Ausführungsform ist das Betätigungselement 105 um die Achse 110 drehbar gelagert, eine Verschiebbarkeit entlang der Achse 110 wäre jedoch ebenfalls möglich.

Die Sensoranordnung 115 umfasst eine elektrische Spule 120 zur Bereitstellung eines Magnetfelds 125, wobei die Spule 120 bevorzugt im Wesentlichen koaxial zur Achse 110 angebracht ist. Idealerweise fallen eine Wicklungsachse der Spule 120 und die Achse 110 zusammen oder liegen möglichst parallel. Weiter umfasst die Sensoranordnung 115 einen Magnetfeldsensor 130, sowie ein magnetisches Flusselement 135, das dazu eingerichtet ist, das Magnetfeld 125 zwischen der Spule 120 und dem Magnetfeldsensor 130 zu führen. Dazu ist das Flusselement 135 bevorzugt aus einem Material mit geringem magnetischem Widerstand herstellbar, beispielsweise aus einem weichmagnetischen Eisen, insbesondere mit einer Permeabilität im Bereich von ca. 100 bis 10.000.

Das Flusselement 135 kann am Betätigungselement 105 angebracht sein, beispielsweise mittels der dargestellten konischen Klemmung oder auch mittels Kleben oder Pressen auf eine andere Weise. Eine form- oder kraftschlüssige Anbringung ist ebenfalls möglich. Das Betätigungselement 105 ist bevorzugt aus einem Material mit einem hohen magnetischen Widerstand herstellbar, insbesondere mit einer Permeabilität von ca. 1. Das Betätigungselement 105 kann paramagnetisch oder dimagnetisch sein und beispielsweise Aluminium oder einen Kunststoff umfassen. Der hohe magnetische Widerstand dient dazu, das Magnetfeld 125 im Bereich des Magnetfeldsensors 130 im Wesentlichen unabhängig von den Eigenschaften des Betätigungselements 105 zu machen. Stattdessen soll das Magnetfeld 125 am Magnetfeldsensor 130 möglichst ausschließlich durch die Eigenschaften und die Position des Flusselements 135 abhängig sein. In einer anderen Variante sind das Betätigungselement 105 und das Flusselement 135 miteinander integriert ausgeführt, sodass gleichzeitig Funktionen der Kraftübertragung und der Führung des Magnetfelds 125 von nur einem Bauteil ausgefüllt werden.

Der Magnetfeldsensor 130 ist bevorzugt bezüglich der Achse 110 axial gegenüber der Spule 120 versetzt angebracht. Das sich ebenfalls axial erstreckende Flusselement 135 führt oder leitet das Magnetfeld 125 in den Bereich des Magnetfeldsensors 130. Dabei ist das Flusselement 135 insbesondere in einem dem Magnetfeldsensor 130 zugewandten axialen Bereich derart ausgebildet, dass die Stärke und/oder Richtung des Magnetfelds 125 am Magnetfeldsensor 130 von der Position des beweglichen Flusselements 135 abhängig ist. In der dargestellten Ausführungsform umfasst das Flusselement 135 hierfür einen radialen Fortsatz, der sich ja nach Drehposition des Betätigungselements mehr oder weniger in Richtung des Magnetfeldsensors 130 erstreckt. Die Breite eines Spalts zwischen dem Flusselement 135 und dem Magnetfeldsensor 130, und somit die Stärke des Magnetfelds 125, kann somit von der Drehposition des Betätigungselements 105 abhängig sein. Bei entsprechender Formgebung des Fortsatzes kann auch die Richtung des Magnetfelds 125 im Bereich des Magnetfeldsensors 130 von der Position des Flusselements 135 abhängig sein.

Eine Verarbeitungseinrichtung 140 kann zur Bestimmung der Position des Flusselements 135 oder des damit verbundenen Betätigungselements 105 vorgesehen sein. Dabei kann die Verarbeitungseinrichtung 140 einen Strom durch die Spule 120 bestimmen oder steuern und vom Magnetfeldsensor 130 ein Signal erfassen, das auf ein Magnetfeld 125 hinweist, das in seinem Bereich herrscht.

Der Magnetfeldsensor 130 kann beispielsweise auf dem magnetoresistiven Effekt basieren, bei dem der elektrische Widerstand eines Materials durch Anlegen eines äußeren Magnetfeldes verändert wird, beispielsweise dem anisotropen magnetoresistiven Effekt (AMR-Effekt), dem Riesenmagnetowiderstandseffekt (GMR-Effekt), dem Kolossalen Magnetoresistiven Effekt (CMR), dem magnetischen Tunnelwiderstand (TMR) oder dem planaren Hall-Effekt. Bevorzugt ist der Magnetfeldsensor 130 als integrierter Halbleiter aufgebaut. Dabei kann er das Magnetfeld 125 in Richtung und/oder Stärke entlang einer oder mehrerer Raumrichtungen bestimmen.

Die Raumrichtungen können paarweise aufeinander senkrecht stehen und auch Dimensionen genannt werden. Insbesondere kann der Magnetfeldsensor 130 dazu eingerichtet sein, eine Bestimmung des Magnetfelds 125 in zwei (2D) oder drei Dimensionen (3D) durchzuführen. Ein nach außen bereitgestelltes Signal kann Stärken des Magnetfelds 125 entlang der einzelnen Raumrichtungen umfassen oder beispielsweise als Vektor in Betrag und Richtung bezüglich der Raumrichtungen angegeben sein. Ist der Magnetfeldsensor 130 dazu eingerichtet, das Magnetfeld 125 entlang mehr als einer Raumrichtung zu bestimmen, so ist bevorzugt, dass der Magnetfeldsensor 130 derart im Magnetfeld 125 orientiert ist, dass eine aufgrund einer Positionsänderung des Flusselements 130 bewirkte Änderung des Magnetfelds 125 mehr als eine, idealerweise alle abgetasteten Raumrichtungen betrifft.

Es wird vorgeschlagen, dass die Verarbeitungseinrichtung 140 dazu eingerichtet ist, alternativ oder zusätzlich zur Positionsbestimmung eine Überprüfung der Sensoranordnung 115 durchzuführen. Dazu kann sie insbesondere das durch die Spule 120 bereitgestellte Magnetfeld 125 durch Anpassen des durch die Spule 120 fließenden Stroms verändern. Vor und nach dem Verändern kann sie das im Bereich des Magnetsensors 130 herrschende Magnetfeld 125 bestimmen. Auf der Basis der beiden Messungen kann bestimmt werden, ob eine Veränderung des gemessenen Magnetfelds 125 einer Veränderung entspricht, die aufgrund der Veränderung des Stroms erwartet wurde. Hierfür ist bevorzugt, dass der Magnetfeldsensor 130 dazu eingerichtet ist, das Magnetfeld 125 entweder digital in ausreichend vielen Stufen oder analog zu bestimmen. Ein binär anzeigender Magnetfeldsensor 130 ist für die Überprüfung nicht ausreichend, auch wenn nur zwei Positionen des Flusselements 135 voneinander unterschieden werden sollen.

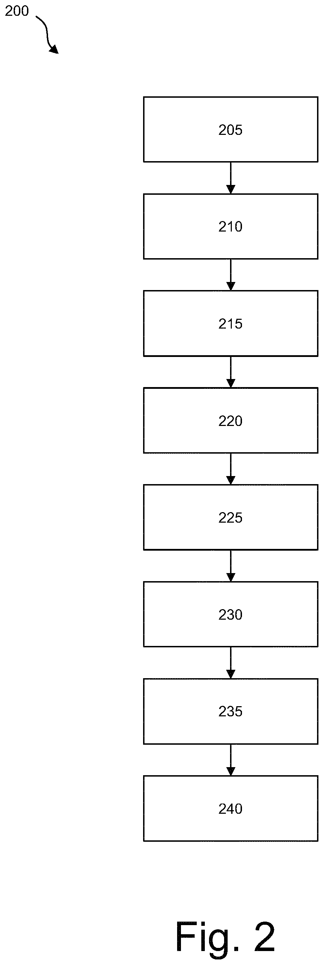

Figur 2 zeigt ein Ablaufdiagramm eines Verfahrens 200. Das Verfahren 200 kann auf der Sensoranordnung 115 ausgeführt werden und umfasst streng genommen ein erstes Verfahren zum Bestimmen der Position des Flusselements 135 und ein verschränktes zweites Verfahren zum Überprüfen der Funktionsfähigkeit der Sensoranordnung 115. Da die Verfahren bestimmte Schritte gemein haben und üblicherweise beide Resultate relevant sind, stellt das dargestellte Verfahren 200 beide Ergebnisse bereit, auch wenn das erste und das zweite Verfahren jeweils auch allein ablauffähig sind.

In einem ersten Schritt 205 wird ein erster Strom durch die Spule 120 gesteuert. In einem Schritt 210 wird ein erstes Magnetfeld 125 bestimmt, das sich im Bereich des Magnetfeldsensors 130 einstellt, indem zum Beispiel ein Messwert vom Magnetfeldsensor 130 abgetastet wird. Zwischen dem Ansteuern und dem Messen kann eine vorbestimmte Zeit abgewartet werden, bis das Magnetfeld 125 stabil ist. Das erste bestimmte Magnetfeld 125 kann abgespeichert werden. In einem optionalen Schritt 215 kann auf der Basis des ersten bestimmten Magnetfelds 125 die Position des Flusselements 135 bestimmt werden. Die bestimmte Position kann nach Außen bereitgestellt werden, beispielsweise an einen Datenbus oder ein Steuergerät.

In einem Schritt 220 wird ein zweiter Strom durch die Spule 120 gesteuert. Der zweite Strom unterscheidet sich vom ersten Strom und bevorzugt auch von null. In einem Schritt 225 wird eine zweite Bestimmung des Magnetfelds 125 durchgeführt. Die Schritte 220 und 225 entsprechen im Wesentlichen den Schritten 205 und 210.

Zur Überprüfung der Sensoranordnung 115 kann in einem Schritt 230 bestimmt werden, wie sich das Magnetfeld 125 aufgrund der Änderung des Stroms durch die Spule zwischen den Schritten 205 und 220 verändert haben sollte. Die erwartete Änderung des Magnetfelds 125 in Abhängigkeit der Änderung des Stroms kann beispielsweise zuvor an einer baugleichen Sensoranordnung 115 empirisch bestimmt worden sein. Dabei kann auch die Position des Flusselements 135 berücksichtigt sein. Ergebnisse können in Form einer Tabelle, einer Kurve oder eines Kennfelds vorliegen. Alternativ kann die erwartete Änderung auch auf der Basis eines physikalischen Modells der Sensoranordnung 115 analytisch bestimmt werden. In einem Schritt 235 wird bestimmt, wie die Änderung des gemessenen Magnetfelds 125 ist.

In einem Schritt 240 wird bestimmt, ob die beiden Bestimmungen zueinander korrespondieren. Insbesondere kann bestimmt werden, ob sie sich weniger als ein vorbestimmtes Maß voneinander unterscheiden. Die Betrachtung kann eine Stärke und/oder eine Richtung des am Magnetfeldsensor 130 bestimmten Magnetfelds 125 umfassen. Es können auch Stärken entlang vorbestimmter Raumrichtungen überprüft werden. Wird eine größere als eine vorbestimmte Abweichung zwischen den Veränderungen bestimmt, so kann ein Fehlersignal ausgegeben werden.

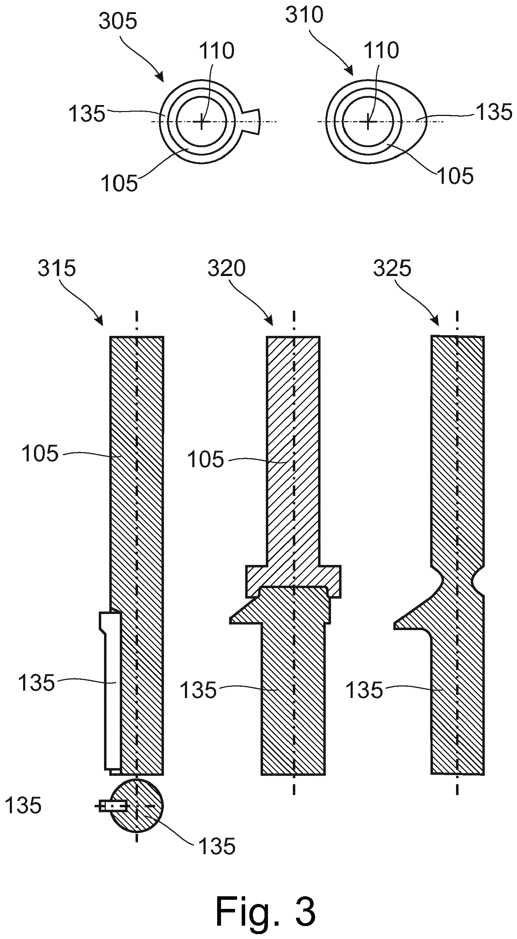

Figur 3 zeigt beispielhafte Ausführungsformen eines magnetischen Flusselements 135. Die dargestellten Flusselemente 135 sind jeweils für eine Drehbetätigung um die Achse 110 eingerichtet, die auch mit Bezug auf Figur 1 beschrieben wurde.

Eine erste Ausführungsform 305 zeigt eine axiale Ansicht oder einen Querschnitt im Bereich des Magnetfeldsensors 130. Das Flusselement 135 ist hier im Wesentlichen radialsymmetrisch ausgebildet und umfasst einen radialen Vorsprung, der sich nach Art eines Kreissektors über einen vorbestimmten Winkel und eine vorbestimmte Distanz radial nach außen erstreckt.

Eine zweite Ausführungsform 310 ist in einer ähnlichen Ansicht dargestellt, wobei hier das Flusselement 135 bezüglich der Achse 110 in Nockenform ausgebildet ist. Alternativ kann das Flusselement 135 in dieser Ansicht auch die Form einer exzentrischen Kreisscheibe aufweisen.

Eine dritte Ausführungsform 315 des Flusselements 135 ist als Längsschnitt und als stirnseitige Axialansicht dargestellt. Das Flusselement 135 ist orientiert wie in der Darstellung von Figur 1, sodass ein unterer Abschnitt im Bereich der Spule 110 und ein mittlerer oder oberer Abschnitt im Bereich des Magnetfeldsensors 130 liegt. Das Betätigungselement 105 ist als Welle mit einer radialen Nut ausgeführt, die in axialer Richtung verläuft. In dieser Nut liegt das Flusselement 135, welches im Wesentlichen quaderförmig, beispielsweise als Blatt, Feder oder Scheibenkeil, ausgebildet sein kann. Das Betätigungselement 105 hat einen hohen magnetischen Widerstand und das Flusselement 135 einen niedrigen.

Eine vierte Ausführungsform 320 des Flusselements 135 ist als Längsschnitt dargestellt. Das Betätigungselement 105 grenzt stirnseitig an das magnetische Flusselement 135 an, welches an einer axialen Position, die im Bereich des Magnetfeldsensors 130 liegt, einen radialen Fortsatz trägt. Der Fortsatz erstreckt sich bevorzugt auf einer der Spule 120 zugewandten axialen Seite in radialer Richtung; auf einer entgegengesetzten axialen Seite kann wie dargestellt ein schräger Übergang radial nach innen ausgebildet sein. Auch in dieser Ausführungsform hat das Betätigungselement 105 bevorzugt einen hohen und das Flusselement 135 einen niedrigen magnetischen Widerstand. Das Flusselement 135 kann Torsionskräfte bei Betätigung des Betätigungselements 105 übertragen. Die beiden Elemente 105, 135 können stoffschlüssig miteinander verbunden sein, beispielsweise indem das Betätigungselement aus einem Kunststoff an das Flusselement 135 angeklebt oder angespritzt wird. Eine formschlüssige Kraftübertragung, insbesondere entlang einer plygonförmigen Umfangslinie, ist ebenfalls möglich.

Eine fünfte Ausführungsform 325 des Flusselements 135 ist ebenfalls als Längsschnitt dargestellt. Ein sich axial in Richtung der Spule 110 erstreckender Abschnitt ist zylindrisch geformt und grenzt an einen Abschnitt mit einem Vorsprung ähnlich dem der vierten Ausführungsform 320. Axial jenseits des Vorsprungs kann eine radiale Einkerbung, Einschnürung oder Engstelle des Flusselements 135 vorgesehen sein, die dazu dient, den magnetischen Fluss im Material einem erhöhten Widerstand auszusetzen, um ein radiales Ausbreiten des magnetischen Feldes 125 in Richtung des Vorsprungs zu fördern. In dieser Ausführungsform kann das Flusselement 135 einstückig integriert mit dem Betätigungselement 105 ausgeführt sein. Der erhöhte magnetische Widerstand an der Engstelle kann hierbei den Übergang zwischen den beiden Elementen 105, 135 markieren. In einer weiteren Variante können auch zwei separate Elemente 105, 135 axial miteinander verbunden sein wie in der vierten Ausführungsform 320.

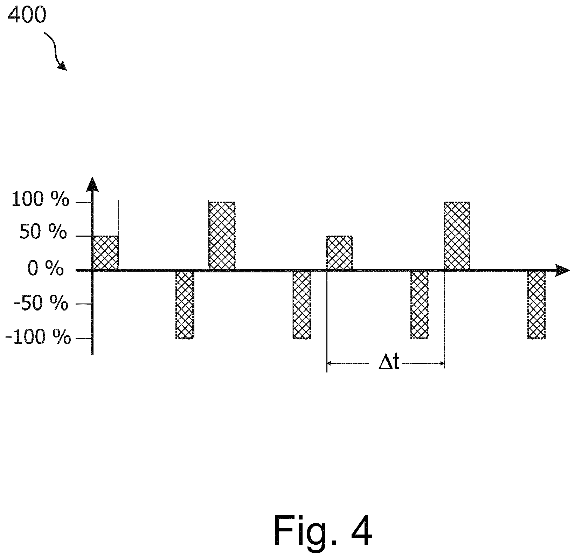

Figur 4 zeigt einen beispielhaften zeitlichen Ablauf 400 verschiedener Messungen an einer Sensoranordnung 115. In horizontaler Richtung ist eine Zeit t und in vertikaler Richtung ein durch die Spule 110 angesteuerter Strom I dargestellt. Eine Verformung des Signals aufgrund der Induktivität der Spule 110 wird in der Darstellung vernachlässigt.

In bevorzugt regelmäßigen Abständen Δt erfolgen Bestimmungen der Position des Flusselements 135, wozu jeweils für eine vorbestimmte Zeit ein positiver Strom durch die Spule 110 gesteuert wird. Optional werden nacheinander Messungen mit unterschiedlich starken Strömen durchgeführt; in der dargestellten Ausführungsform wird der Strom in zwei Stufen abwechselnd auf beispielhafte 50 % und 100 % eines vorbestimmten Werts gesteuert. Andere Werte oder mehr als zwei unterschiedlich starke Ströme sind ebenfalls möglich. Auch kann der Strom sein Vorzeichen wechseln oder stets negativ sein.

Zwischen Messungen kann eine Überprüfung der Sensoranordnung 115 durchgeführt werden, wozu in der vorliegenden Ausführungsform eine andere Polarität des Stroms als für die Positionsbestimmung verwendet wird. Die Überprüfung erfolgt bevorzugt bei 100 % der vorbestimmten Stromstärke, um ein möglichst eindeutiges Ergebnis zu erhalten. Die Dauer einer Positionsbestimmung oder Überprüfung ist hauptsächlich davon abhängig, wie schnell ein vorbestimmtes Magnetfeld 125 bewirkt werden kann und wie lange der Magnetfeldsensor 130 für eine Bestimmung benötigt. Eine Periode Δt kann in Abhängigkeit einer gewünschten Messhäufigkeit gewählt werden und in einer üblichen Anwendung an einem Kraftfahrzeug ca. 5 - 30 ms dauern. Es ist bevorzugt, dass zwischen den Messungen oder Überprüfungen Pausen eingehalten werden. In der dargestellten Ausführungsform sind die Pausen innerhalb einer Periode Δt insgesamt etwa dreimal so lang wie die zusammen genommenen Messdauern.

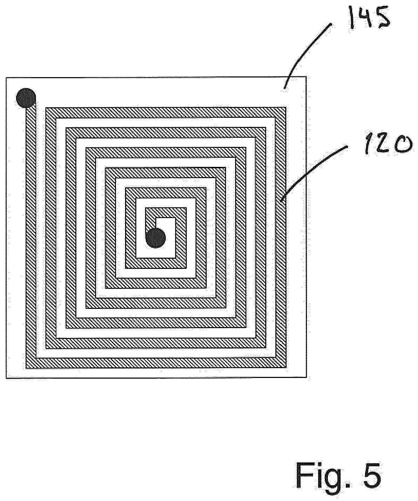

Fig 5 zeigt eine Draufsicht einer Ausführungsform einer Spule für eine Sensoranordnung 115 gemäß einer Ausführungsform der Erfindung. Die Spule 120 ist als gedruckte Spule an einer Leiterplatte 145 ausgebildet. Die Spule 120 kann für die dynamische Positionsermittlung verwendet werden. Dadurch dass die Spule 120 nun als eine Struktur auf der Leiterplatte 145 ausgebildet ist können die Kosten für eine aufgewickelte Spule eingespart werden. Stattdessen wird die Spule 120 beim Herstellungsprozess der Leiterplatte 145 erzeugt, ohne dass Mehrkosten entstehen.

### Bezuaszeichen

- 100: Eingabevorrichtung
- 105: Betätigungselement
- 110: Achse
- 115: Sensoranordnung
- 120: elektrische Spule
- 125: Magnetfeld
- 130: Magnetfeldsensor
- 135: magnetisches Flusselement
- 140: Verarbeitungseinrichtung

- 200: Verfahren
- 205: Steuern ersten Strom
- 210: Bestimmen erstes Magnetfeld
- 215: Bestimmen Position, Bereitstellen Position
- 220: Steuern zweiten Strom
- 225: Bestimmen zweites Magnetfeld
- 230: Bestimmen Soll-Änderung Magnetfeld
- 235: Bestimmen Ist-Änderung Magnetfeld
- 240: Änderungen korrespondieren zueinander?

- 305: erste Ausführungsform
- 310: zweite Ausführungsform
- 315: dritte Ausführungsform
- 320: vierte Ausführungsform
- 325: fünfte Ausführungsform

- 400: Ablauf

## Patentansprüche

1. Sensoranordnung (115) zur Steuerung einer Funktion an Bord eines Kraftfahrzeugs, wobei die Sensoranordnung (115) folgendes umfasst: eine elektrische Spule (120) zur Bereitstellung eines Magnetfeldes (125); einen Magnetfeldsensor (130); ein magnetisches Flusselement (135) zur Führung des Magnetfeldes (125) zwischen der Spule (120) und dem Magnetfeldsensor (130); wobei das magnetische Flusselement (135) beweglich gelagert und derart geformt ist, und wobei das im Bereich des Magnetfeldsensors (130) herrschende Magnetfeld (125) von einer Position des Flusselements (135) abhängig ist; ferner umfassend eine Verarbeitungseinrichtung (140) zur Bestimmung der Position des Flusselements (135) auf der Basis des mittels des Magnetfeldsensors (130) bestimmten Magnetfelds (125), **dadurch gekennzeichnet, dass** das Flusselement (135) bezüglich einer vorbestimmten Achse (110) beweglich ist; und die Spule (120) und der Magnetfeldsensor (130) bezüglich dieser Achse (110) axial versetzt sind.

2. Sensoranordnung (115) nach Anspruch 1, wobei die Verarbeitungseinrichtung (140) dazu eingerichtet ist, einen durch die Spule (120) fließenden Strom zu verändern, und zu bestimmen, ob eine Veränderung des mittels des Magnetfeldsensors (130) bestimmten Magnetfelds (125) einer aufgrund der Veränderung des Stroms erwarteten Veränderung entspricht.

3. Sensoranordnung (115) nach Anspruch 1 oder 2, wobei das magnetische Flusselement (135) derart geformt ist, dass eine Richtung des im Bereich des Magnetfeldsensors (130) herrschenden Magnetfelds (125) von einer Position des Flusselements (135) abhängig ist und der Magnetfeldsensor (130) dazu eingerichtet ist, die Richtung des in seinem Bereich herrschenden Magnetfelds (125) zu bestimmen.

4. Sensoranordnung (115) nach einem der vorangehenden Ansprüche, wobei das Flusselement (135) derart geformt ist, dass die Breite eines Spalts zwischen dem Flusselement (135) und dem Magnetfeldsensor (130) von der Position des Flusselements (135) abhängig ist.

5. Sensoranordnung (115) nach einem der vorangehenden Ansprüche, wobei der Magnetfeldsensor (130) dazu eingerichtet ist, das Magnetfeld (125) entlang mehrerer unterschiedlicher Raumrichtungen zu bestimmen.

6. Sensoranordnung (115) nach Anspruch 5, wobei der Magnetfeldsensor (130) derart angebracht ist, dass bei einer Änderung der Position des Flusselements (135) das Magnetfeld (125) am Magnetfeldsensor (130) entlang von wenigstens zwei Raumrichtungen verändert wird.

7. Sensoranordnung (115) nach einem der vorangehenden Ansprüche, **dadurch gekennzeichnet, dass** die Spule (120) eine Struktur auf einer Leiterplatte darstellt.

8. Verfahren (200) zur Steuerung einer Funktion an Bord eines Kraftfahrzeugs, mit folgenden Schritten: Bereitstellen (205) eines Magnetfeldes (125) mittels einer elektrischen Spule (120); Bestimmen (210) eines im Bereich eines Magnetfeldsensors (130) herrschenden Magnetfelds (125); wobei ein magnetisches Flusselement (135), das zur Führung des Magnetfeldes (125) zwischen der Spule (120) und dem Magnetfeldsensor (130) eingerichtet ist, beweglich gelagert ist; wobei das magnetische Flusselement (135) derart geformt ist, dass das im Bereich des Magnetfeldsensors (130) herrschende Magnetfeld (125) von einer Position des Flusselements (135) abhängig ist, und wobei das Flusselement (135) bezüglich einer vorbestimmten Achse (110) beweglich ist; und die Spule (120) und der Magnetfeldsensor (130) bezüglich dieser Achse (110) axial versetzt sind; und Bestimmen (215) der Position des Flusselements (135) auf der Basis des mittels des Magnetfeldsensors (130) bestimmten Magnetfelds (125).

9. Verfahren (200) nach Anspruch 8, wobei ferner ein durch die Spule (120) fließender Strom verändert und bestimmt wird, ob eine Veränderung des mittels des Magnetfeldsensors (130) bestimmten Magnetfelds (125) einer aufgrund der Veränderung des Stroms erwarteten Veränderung entspricht.

10. Verfahren (200) nach Anspruch 8, wobei Stromrichtungen zur Bestimmung der Position des Flusselements (135) und zur Bestimmung der Veränderung entgegengesetzte Polaritäten aufweisen.

11. Verwendung einer Sensoranordnung (115) nach Ansprüchen 1 - 7 in einem Drehschalter eines Fahrzeugs, um eine Drehstellung des Drehschalters zu bestimmen.

## Claims

1. Sensor arrangement (115) for controlling a function on board a motor vehicle, wherein the sensor arrangement (115) comprises the following: an electrical coil (120) for providing a magnetic field (125); a magnetic field sensor (130); a magnetic flux element (135) for guiding the magnetic field (125) between the coil (120) and the magnetic field sensor (130); wherein the magnetic flux element (135) is mounted movably and is shaped in such a way that the magnetic field (125) prevailing in the region of the magnetic field sensor (130) is dependent on a position of the flux element (135); furthermore comprising a processing device (140) for determining the position of the flux element (135) on the basis of the magnetic field (125) determined by means of the magnetic field sensor (130), **characterized in that** the flux element (135) is movable in relation to a predetermined axis (110); and the coil (120) and the magnetic field sensor (130) are offset axially in relation to this axis (110) .

2. Sensor arrangement (115) according to Claim 1, wherein the processing device (140) is configured to change a current flowing through the coil (120), and to determine whether a change in the magnetic field (125) determined by means of the magnetic field sensor (130) corresponds to a change expected on account of the change in the current.

3. Sensor arrangement (115) according to Claim 1 or 2, wherein the magnetic flux element (135) is shaped in such a way that a direction of the magnetic field (125) prevailing in the region of the magnetic field sensor (130) is dependent on a position of the flux element (135), and the magnetic field sensor (130) is configured to determine the direction of the magnetic field (125) prevailing in the region thereof.

4. Sensor arrangement (115) according to any of the preceding claims, wherein the flux element (135) is shaped in such a way that the width of a gap between the flux element (135) and the magnetic field sensor (130) is dependent on the position of the flux element (135).

5. Sensor arrangement (115) according to any of the preceding claims, wherein the magnetic field sensor (130) is configured to determine the magnetic field (125) along a plurality of different spatial directions.

6. Sensor arrangement (115) according to Claim 5, wherein the magnetic field sensor (130) is fitted in such a way that in the event of a change in the position of the flux element (135), the magnetic field (125) at the magnetic field sensor (130) is changed along at least two spatial directions.

7. Sensor arrangement (115) according to any of the preceding claims, **characterized in that** the coil (120) constitutes a structure on a printed circuit board.

8. Method (200) for controlling a function on board a motor vehicle, comprising the following steps: providing (205) a magnetic field (125) by means of an electrical coil (120); determining (210) a magnetic field (125) prevailing in the region of a magnetic field sensor (130); wherein a magnetic flux element (135) configured for guiding the magnetic field (125) between the coil (120) and the magnetic field sensor (130) is mounted movably; wherein the magnetic flux element (135) is shaped in such a way that the magnetic field (125) prevailing in the region of the magnetic field sensor (130) is dependent on a position of the flux element (135), and wherein the flux element (135) is movable in relation to a predetermined axis (110); and the coil (120) and the magnetic field sensor (130) are offset axially in relation to this axis (110); and determining (215) the position of the flux element (135) on the basis of the magnetic field (125) determined by means of the magnetic field sensor (130).

9. Method (200) according to Claim 8, wherein furthermore a current flowing through the coil (120) is changed and the method involves determining whether a change in the magnetic field (125) determined by means of the magnetic field sensor (130) corresponds to a change expected on account of the change in the current.

10. Method (200) according to Claim 8, wherein current directions for determining the position of the flux element (135) and for determining the change have opposite polarities.

11. Use of a sensor arrangement (115) according to Claims 1 - 7 in a rotary switch of a vehicle in order to determine a rotary position of the rotary switch.

## Revendications

1. Arrangement capteur (115) destiné à commander une fonction à bord d'un véhicule automobile, l'arrangement capteur (115) comprenant ce qui suit : une bobine électrique (120) destinée à fournir un champ magnétique (125) ; un capteur de champ magnétique (130) ; un élément de flux magnétique (135) destiné à guider le champ magnétique (125) entre la bobine (120) et le capteur de champ magnétique (130) ; l'élément de flux magnétique (135) étant monté mobile et étant façonné de telle sorte que le champ magnétique (125) qui règne dans la zone du capteur de champ magnétique (130) est dépendant d'une position de l'élément de flux (135) ; comprenant en outre un dispositif de traitement (140) destiné à déterminer la position de l'élément de flux (135) sur la base du champ magnétique (125) déterminé au moyen du capteur de champ magnétique (130), **caractérisé en ce que** l'élément de flux (135) est mobile en référence à un axe (110) prédéterminé ; et la bobine (120) ainsi que le capteur de champ magnétique (130) sont décalés axialement en référence à cet axe (110).

2. Arrangement capteur (115) selon la revendication 1, le dispositif de traitement (140) étant conçu pour modifier un courant qui circule à travers la bobine (120) et pour déterminer si une modification du champ magnétique (125) déterminé au moyen du capteur de champ magnétique (130) correspond à une modification attendue du fait de la modification du courant.

3. Arrangement capteur (115) selon la revendication 1 ou 2, l'élément de flux magnétique (135) étant façonné de telle sorte qu'une direction du champ magnétique (125) qui règne dans la zone du capteur de champ magnétique (130) est dépendante d'une position de l'élément de flux (135) et le capteur de champ magnétique (130) est conçu pour déterminer la direction du champ magnétique (125) qui règne dans sa zone.

4. Arrangement capteur (115) selon l'une des revendications précédentes, l'élément de flux magnétique (135) étant façonné de telle sorte que la largeur d'un interstice entre l'élément de flux (135) et le capteur de champ magnétique (130) est dépendante de la position de l'élément de flux (135).

5. Arrangement capteur (115) selon l'une des revendications précédentes, le capteur de champ magnétique (130) étant conçu pour déterminer le champ magnétique (125) le long de plusieurs directions spatiales différentes.

6. Arrangement capteur (115) selon la revendication 5, le capteur de champ magnétique (130) étant monté de telle sorte que dans le cas d'une modification de la position de l'élément de flux (135), le champ magnétique (125) au niveau du capteur de champ magnétique (130) est modifié le long d'au moins deux directions spatiales.

7. Arrangement capteur (115) selon l'une des revendications précédentes, **caractérisé en ce que** la bobine (120) représente une structure sur un circuit imprimé.

8. Procédé (200) pour commander une fonction à bord d'un véhicule automobile, comprenant les étapes suivantes : fourniture (205) d'un champ magnétique (125) au moyen d'une bobine électrique (120) ; détermination (210) d'un champ magnétique (125) qui règne dans la zone d'un capteur de champ magnétique (130) ; un élément de flux magnétique (135) qui est conçu pour guider le champ magnétique (125) entre la bobine (120) et le capteur de champ magnétique (130) étant monté mobile ; l'élément de flux magnétique (135) étant façonné de la sorte que le champ magnétique (125) qui règne dans la zone du capteur de champ magnétique (130) est dépendant d'une position de l'élément de flux (135), et l'élément de flux (135) étant mobile en référence à un axe (110) prédéterminé ; et la bobine (120) ainsi que le capteur de champ magnétique (130) étant décalés axialement en référence à cet axe (110) ; et détermination (215) de la position de l'élément de flux (135) sur la base du champ magnétique (125) déterminé au moyen du capteur de champ magnétique (130) .

9. Procédé (200) selon la revendication 8, un courant qui circuit à travers la bobine (120) étant en outre modifié et le fait qu'une modification du champ magnétique (125) déterminé au moyen du capteur de champ magnétique (130) corresponde à une modification attendue du fait de la modification du courant étant déterminé.

10. Procédé (200) selon la revendication 8, les directions du courant servant à la détermination de la position de l'élément de flux (135) et à la détermination de la modification présentant des polarités opposées.

11. Utilisation d'un arrangement capteur (115) selon les revendications 1 à 7 dans un commutateur rotatif d'un véhicule afin de déterminer une position de rotation du commutateur rotatif.
